# EUROPEAN PATENT APPLICATION

(11) **EP 0 914 904 A2**
(43) Date of publication of application: **12.05.1999**
(21) Application number: 98309026.7
(22) Date of filing: 04.11.1998
(51) Int. Cl.: B24B 37/04, B24B 57/02, H01L 21/304

(54) **Apparatus for dispensing slurry**

(30) Priority: 05.11.1997 US 965067; 10.07.1998 US 113727
(71) Applicant: Aplex, Inc., Sunnyvale, CA 94086 (US)
(72) Inventor: Mok, Peter, San Francisco, California 94123 (US); Chun, Jon, San Jose, California 95124 (US)
(74) Representative: Freeman, Jacqueline Carol

(57) **Abstract**

A slurry dispenser dispensing slurry by a rotating wheel is provided in a chemical mechanical polishing process used in manufacturing integrated circuits. In a second configuration, the slurry dispenser uses a pair of counter-rotating wheels. The wheels are driven by variable speed motors at a predetermined speed empirically determined to dispense a desired amount of slurry. The shape of the rotating wheels controls the vertical distribution of the spray. Openings in the housing of the slurry dispenser and the speed of rotation of the wheels controls the horizontal distribution of the spray. The slurry dispenser can be constructed out of materials chemically inert with respect to the slurry.

## Description

### BACKGROUND OF THE INVENTION

### 1. Field of the Invention

The present invention relates to dispensing a liquid. In particular, the present invention relates to dispensing slurry in a chemical-mechanical polishing (CMP) application.

### 2. Discussion of the Related Art

In sub-micron integrated circuits, CMP techniques are used to create the planarity required in multi-level interconnect structures. Specifically, to create a planar surface for depositing an interconnect layer, e.g. aluminum, tungsten, or copper, an interlayer dielectric (e.g., silicon dioxide)- is planarized by a polishing process which uses an alkaline or acidic slurry with fine abrasive. One example of such a slurry includes fine silicon dioxide particles (e.g., average diameter of 70 nm) suspended in deionized water having an adjusted pH of approximately 11. The alkalinity can be provided by potassium hydroxide (KOH) and ammonium hydroxide (NH₃OH). For other applications, acidic slurries are used.

Typically, in a CMP polisher, the semiconductor wafer to be polished is held under slight pressure by a polishing head against a polishing pad. For a CMP application, the polishing pad is typically made of a polyurethrane material. During the polishing process, the polishing head moves the semiconductor wafer according to a predetermined motion pattern.
Alternatively, the polishing pad can be mounted on a platform which moves relative to the semiconductor wafer. The motion of the semiconductor wafer relative to the polishing pad and the mechanical and chemical actions of the slurry, together provide a polishing action for planarizing the surface of the wafer. In such a process, because the slurry has a high content of water, the slurry is not only an abrasive, but also acts as a coolant which maintains the surface of the wafer to an acceptable temperature.

In the prior art, the slurry is typically sprayed onto the surface of the polishing pad by appropriately positioned nozzles linked by a slurry supply line, and delivered to the surface of the polishing pad at 50 to 500 cc per minute using a peristalic pump. However, a number of problems can develop over time under this arrangement. In particular, deposits from the slurry can clog the nozzles, leading to uneven and inadequate delivery. In some situations, uneven and inadequate slurry delivery can result in poor polishing uniformity and even severe damage to the wafer due to excessive heat. In addition, even when nozzles are in good working condition, it is difficult to control the amount of slurry that is dispensed. Further, it is important to provide a means of cleaning the slurry dispensing apparatus. When allowed to dry out, slurry forms flakes which, if deposited on semiconductor wafers, can degrade integrated circuit performance.

### SUMMARY OF THE INVENTION

In accordance with the present invention, a slurry dispenser which dispenses slurry from a rotating wheel is provided.

In one embodiment, the slurry dispenser includes: (a) a housing having an opening; (b) a reservoir provided inside the housing for holding the slurry; (c) a rotating mechanism, such as a motor, and (d) a wheel assembly provided within the housing and engaged to rotate with said rotational mechanism. In that embodiment, the wheel assembly includes a conical member inserted into the slurry reservoir and a disk portion. During operation, i.e., while the wheel assembly is rotated by the rotating mechanism, a stream of slurry is forced up a side wall of the conical member of the wheel assembly, so that the slurry is dispensed as a spray by the disk through the opening of the housing. The spray is created by a centrifugal force resulting from the rotation. If a variable speed DC motor is used, the amount of slurry dispensed by the slurry dispenser can be controlled by an applied voltage to the motor.

The housing, the wheels and any surface that comes into contact with the slurry, can be constructed from a synthetic material (e.g., polycarbonate, polypropylene, polyvinylidene fluoride (PVDF), or any material with a teflon coating on exposed surfaces) which is chemically inert with respect to the slurry. In one embodiment, the housing of the slurry dispenser includes wall portions in the proximity of the opening, such that the slurry spray is restricted to a predetermined angle.

An inlet is provided in the slurry dispenser for attaching a slurry supply line to maintain a continuous supply of slurry into the slurry reservoir of the slurry dispenser.

In accordance with the present invention, a self-cleaning slurry dispenser which dispenses slurry from two counter-rotating wheels is also provided.

In one embodiment, the slurry dispenser includes: (a) a housing having two openings; (b) two reservoirs provided inside the housing for holding the slurry; (c) two rotating mechanisms, and (d) two wheels provided within the housing and engaged to rotate with said rotating mechanisms. The rotating mechanisms turn the wheels in opposite directions, providing an overlapping spray of slurry. The shape of the openings in the housing restricts the slurry spray to a predetermined angle.

In one embodiment, the slurry dispenser includes a sliding door operated by an air cylinder and an inlet for cleaning water such that when the sliding door is closed the housing can be washed without operator intervention and without cross contamination between the interior and the exterior of the housing.

The slurry dispensers of the present invention allow even distribution of slurry across the polishing pad and fine control of the amount of slurry dispensed, so that waste of slurry is minimized. Furthermore, a self-cleaning slurry dispenser is provided.

The present invention is better understood upon consideration of the detailed description below in conjunction with the accompanying drawings.

### BRIEF DESCRIPTION OF THE DRAWINGS

Figures 1a and 1b show, respectively, schematic front and side views of a CMP apparatus 100, including a slurry dispenser 104, in accordance with the present invention.

Figure 2a shows an assembled side view of slurry dispenser 104.

Figure 2b shows an "exploded" side view of slurry dispenser 104.

Figure 3a shows a front view of slurry dispenser 104.

Figure 3b illustrates the operation of slurry dispenser 104.

Figure 4 illustrates the operation of slurry dispenser 104 using a vertical sectional view of slurry dispenser 104.

Figure 5 shows a front isometric view of slurry dispenser 124.

Figure 6a shows a back isometric view of slurry dispenser 124.

Figure 6b shows an "exploded" back view of slurry dispenser 124.

Figure 7 shows wheel 250.

Figure 8 shows a top view of wheel housing with the wheels removed to reveal the reservoirs 248.

Figure 9 illustrates the operation of slurry dispenser 124 using a view from the top of the interior of wheel housing 240.

Figures 10 and 1b show, respectively, vertical and horizontal sectional views of slurry dispenser 500, in accordance with the present invention.

### DETAILED DESCRIPTION OF THE PREFERRED EMBODIMENTS

The present invention provides a slurry dispenser free of the problems of the prior art described in the previous section. To simplify the detailed description below, like elements in the figures are provided like reference numerals.

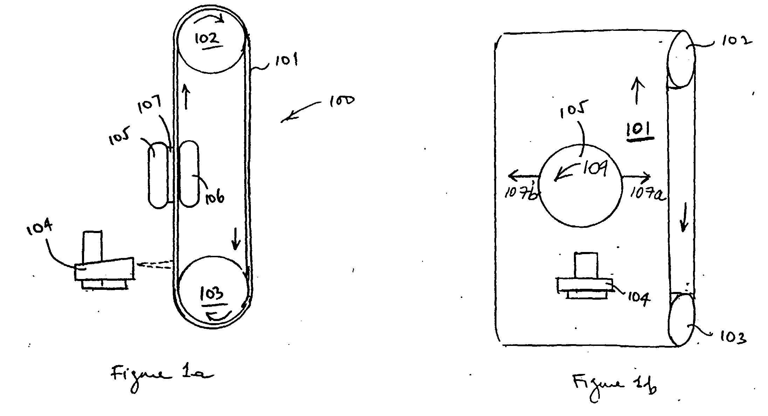

Figures la and 1b show CMP apparatus 100 in side and front views, respectively. As shown in Figures 1a and 1b, CMP apparatus 100 includes a continuous polishing belt 101 configured to polish one or more vertically held semiconductor wafers, such as wafer 107. Wafer 107 is held vertically by a polishing head 105, which presses wafer 107 against a polishing pad attached to a vertically mounted polishing belt 101. Polishing belt 101 is kept in continuous motion by rotating pulleys 102 and 103 at a selected polishing speed (e.g., 10 meters per second). A support assembly 106 provides a backward pressure to hold wafer 107 at a preselected pressure (e.g., 5 psi) against polishing belt 101. Polishing head 105 rotates in a predetermined direction indicated by reference numeral 109 and is optionally moved back and forth across the polishing pad surface in straight lines indicated by reference numerals 107a and 107b. While Figure 1 shows only one side of the polishing belt assembly being used for wafer polishing, polishing heads and accompanying mechanisms can be provided on both sides of the polishing belt assembly of CMP apparatus 100 to increase the total wafer throughput.

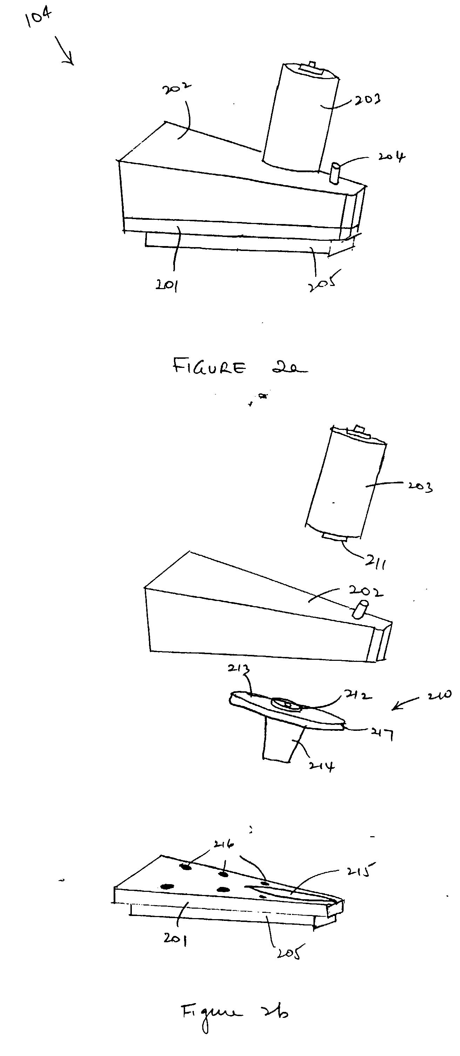

The present invention provides a slurry dispenser 104, which is positioned at a short distance upstream (relative to polishing belt 101's direction of travel) from polishing head 105. Slurry dispenser 104 sprays a fine stream of slurry from a rapidly rotating wheel. Figure 2a provides an assembled side view of slurry dispenser 104. As shown in Figure 2a, slurry dispenser 104 includes (a) a lower housing 201, including a slurry reservoir 205, (b) an upper housing 202, fastened to lower housing 201 by, for example, set screws, and (c) a variable speed motor 203. A component wheel assembly is enclosed between lower and upper housings 201 and 202. Upper housing 202 includes a slurry inlet 204, which is connected during operation to a slurry supply line (not shown) to provide slurry dispenser 104 a continuous supply of slurry. A peristolic pump can be used to provide the slurry in the supply line.

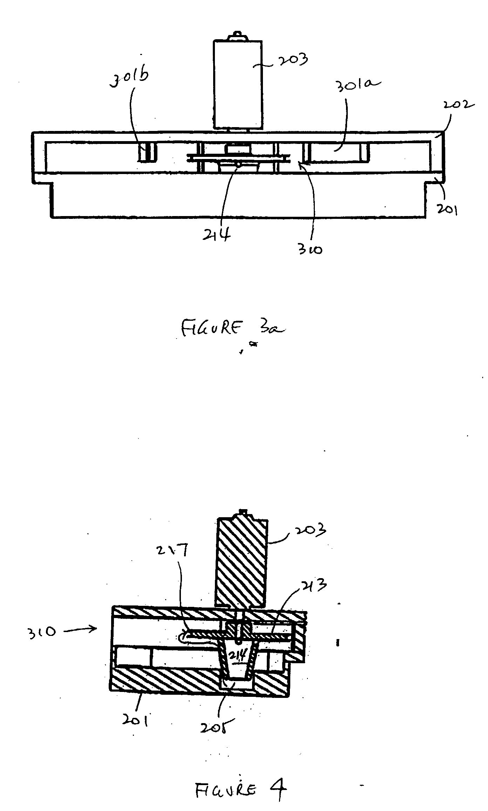

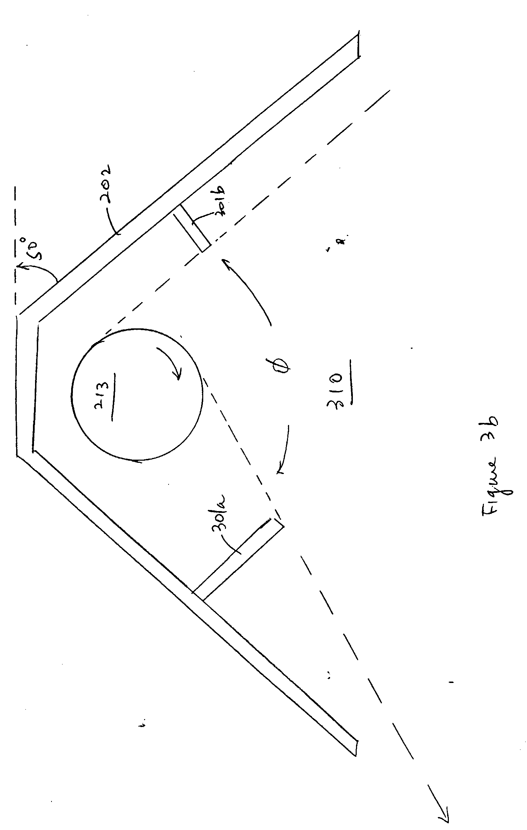

In this embodiment, upper and lower housings 202 and 201, and the component wheel assembly (shown in Figure 2b), can be constructed out of polycarbonate, polypropylene, polyvinylidene fluoride (PVDF), any material with a teflon coating on exposed surfaces, or any other material inert to the slurry (e.g. a hard plastic). Motor 203 is preferably a DC motor which speed can be varied by varying the magnitude of an applied voltage. Upper housing 202 has an opening at the front (i.e., opening 310 shown in Figures 3a, 3b and 4 and described below), so that a spray of slurry can be provided through that opening.

Figure 2a shows an "exploded" side view of slurry dispenser 104. As shown in Figure 2a, in addition to motor 203, and upper and lower housings 201 and 202 (including slurry inlet 204 and slurry reservoir 205), dispenser 104 includes a wheel assembly 210, which has at least these members: (a) a linkage member 212, for engaging a rotating shaft 211 of motor 203, such that, during operation, wheel assembly 210 turns at the speed of motor 203, (b)a wheel or disk portion 213, including a groove 217 between its upper and lower surfaces, and (c) a conical member 214, attached to the lower surface of disk portion 213. Figure 2b also shows a set of through holes 216, through which set screws can be provided to fasten upper housing 202 to lower housing 201, engaging corresponding threaded holes in upper housing 202. Conical member 214 is inserted into opening 215 in lower housing 201. Opening 215 opens into slurry reservoir 205.

A front view of slurry dispenser 104 is provided in Figure 3a, looking from the direction of front opening 310 in upper housing 202. As shown in Figure 3a, two partial walls 301a and 301b are provided from the ceiling of upper housing 202. Partial walls 301a and 301b are provided to restrict the angle of the slurry spray from slurry dispenser 104.

The operation of slurry dispenser 104 is described in conjunction with Figures 3b and Figure 4. Figure 3b is a view of slurry dispenser 104 viewed from the ceiling of upper housing 202 and Figure 4 is a vertical sectional view of slurry dispenser 104. During operation, motor 203 turns wheel assembly 210 at a predetermined speed (e.g., 2000 to 3000 revolutions per minute). The desired operational speed of the motor is primarily determined by the amount of slurry required to be dispensed. Generally, a higher speed would dispense a greater amount of slurry. The actual speed required can be determined empirically. As shown in Figure 4, at the operational speed, a stream of slurry is forced to creep up from slurry reservoir 205 along a side wall of conical member 214, due to the boundary layer created at the surface of conical member 214. This stream of slurry flow continues over the lower surface of disk portion 213 into groove 217. The centrifugal force of spinning wheel assembly 210 spray the slurry from groove 217 out of slurry dispenser 104 through opening 310 of upper housing 202. The sharp edges of disk portion 213, formed by the walls of groove 217, serve to restrict the spray to a thin layer in the vertical direction.

In this embodiment, the sloping sidewalls of conical member 214 are inclined 100 degrees from disk portion 213. As described above, walls 301a and 301b restrict the spray of slurry horizontally to the predetermined angle Ø shown. The magnitude of this angle, hence the length of walls 301a and 301b is determined empirically. Slurry that flows out of slurry dispenser 104 (e.g., slurry caught by the walls of the housings) can be collected and recycled to avoid waste.

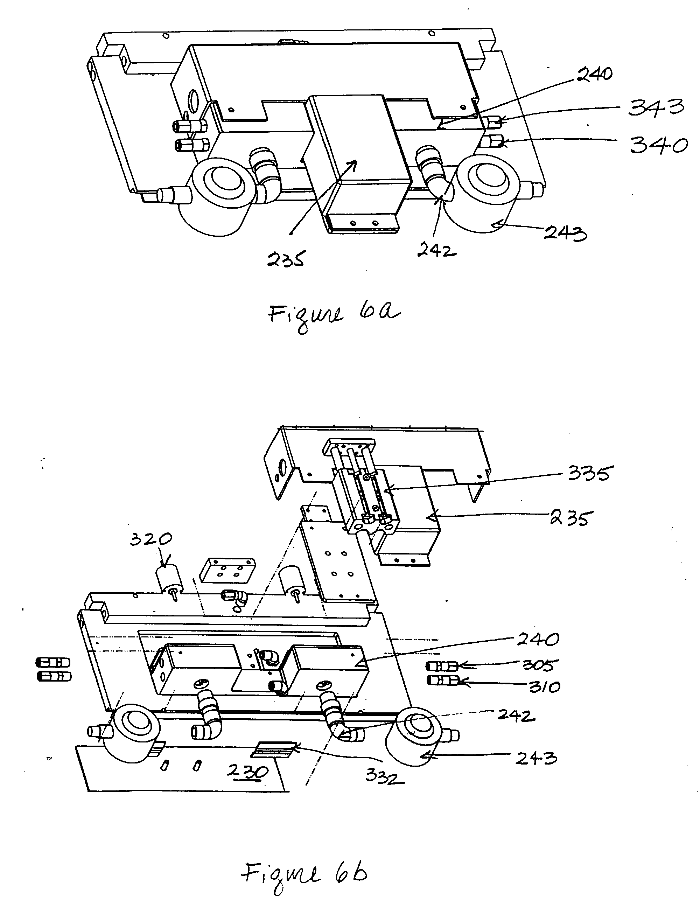

According to a second embodiment of the present invention, a slurry dispenser using two wheels is provided. Slurry dispenser 124 sprays a fine stream of slurry from a pair of rapidly counter-rotating wheels. Figure 5 provides an isometric view of the front of slurry dispenser 124. As shown in Figure 5, slurry dispenser 124 includes a front face 220 with openings 225 to the wheel housing 240 positioned behind the front face. Openings in wheel housing 240 align with the openings 225 in front face 220. The interior of wheel housing 240, contains two wheels 250, positioned above slurry reservoir slots 248 in the bottom face of the housing interior.

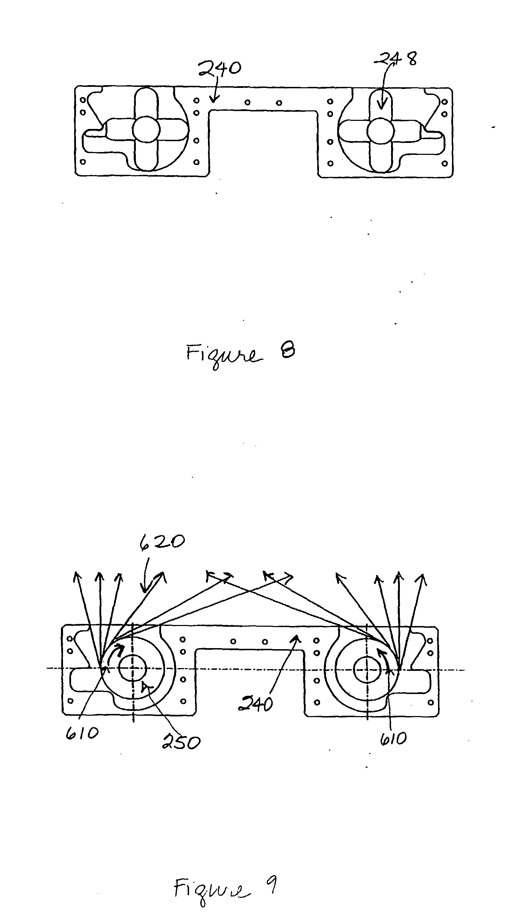

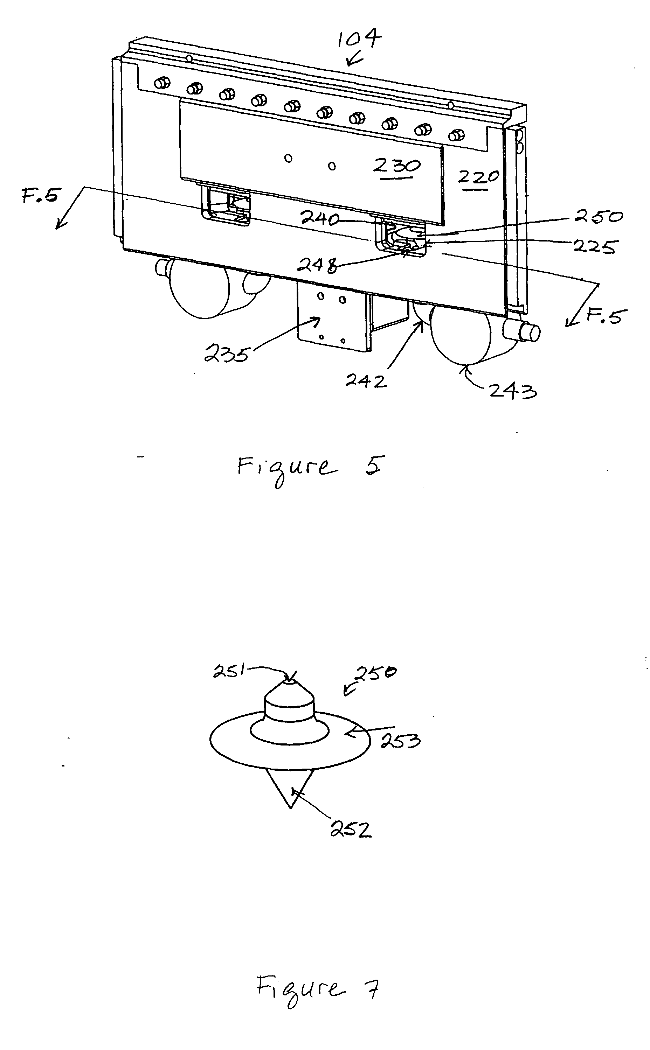

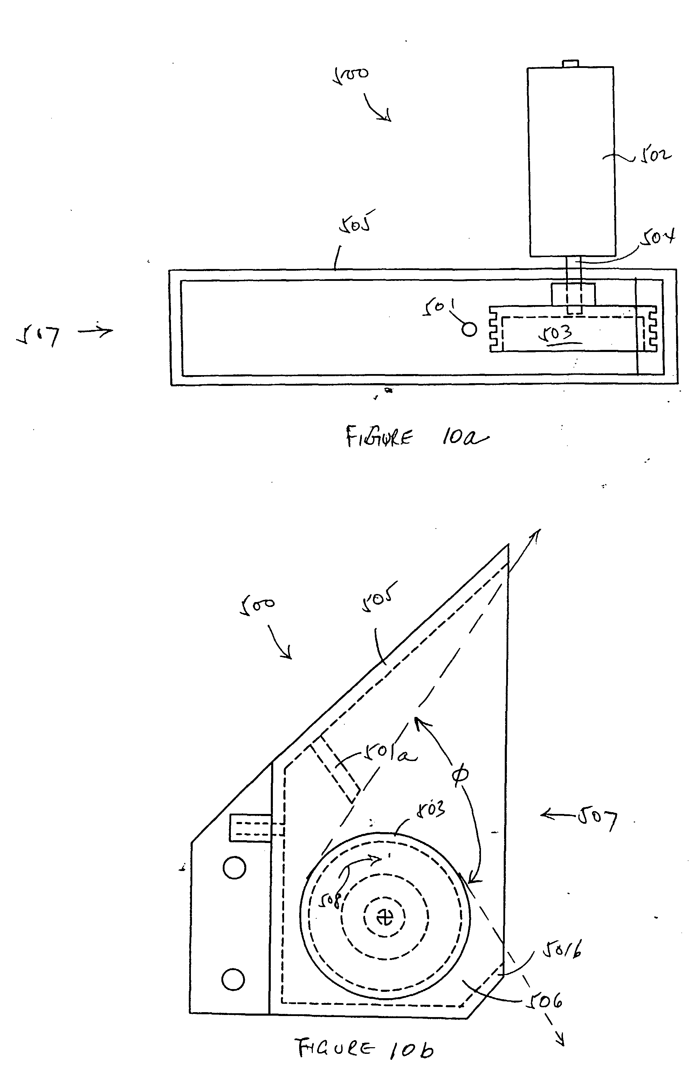

Referring to the back view of slurry dispenser 124 in Figures 6a and 6b, the exterior of wheel housing 240 is shown. Wheel housing 240 is connected to slurry inlet lines 340, which are connected during operation to slurry supply lines (not shown) to provide slurry dispenser 124 a continuous supply of slurry. A peristolic pump can be used to provide the slurry in the supply lines. A pair of variable speed motors 320 is positioned above wheel housing 240. Motors 320 are preferably DC motors. Motors 320 have a rotating shaft extending downward which fits into a slot 251 on the top of wheels 250, as illustrated in Figure 7. The bottom portion of wheels 250 is a conical portion 252. A disk portion 253 is positioned above the conical portion. Two sets of slurry reservoir slots 248 at the bottom of wheel housing 240 are shown in Figure 8, which provides a top view of the wheel housing with the wheels removed. During operation, wheels 250 are placed such that the bottom point of the conical portion 252 is positioned at the center crossing points 249 of slurry reservoir slots 248. The design of slurry reservoir slots 248 advantageously minimizes the use of slurry.

The operation of slurry dispenser 124 is described in conjunction with Figure 9. Figure 9 is a view of slurry dispenser 124 viewed from the ceiling of the interior of wheel housing 240. During operation, motors 203 turns wheels 250 in opposite directions 610 at a predetermined speed (e.g., 3000 to 6000 revolutions per minute) . This provides an overlapping spray of slurry as indicated by slurry distribution arrows 620. The desired operational speed of the motor is primarily determined by the amount of slurry required to be dispensed and the desired distribution pattern. Generally, a higher speed would dispense a greater amount of slurry and provide greater overlap in the center of the distribution. However, a higher speed also results in a smaller droplet size, while a larger droplet size is desired to reduce misting. The preferred speed can be determined empirically as a tradeoff between flow rate and droplet size. A typical rate of supplying slurry through slurry supply lines 340 is approximately 450 ml/min.

At the operational speed, a stream of slurry is forced to creep up from slurry reservoir slots 248 along a side wall of the conical portion 252 of wheels 250, due to the boundary layer created at the surface of the conical portion. This stream of slurry flow continues over the lower surface of the disk portion 253 of wheels 250. The centrifugal force of spinning wheel 250 sprays the slurry out of slurry dispenser 104 through openings of wheel housing 240. The sharp edges of the disk portion of wheels 250 serve to restrict the spray to a thin layer in the vertical direction.

In this embodiment, the sloping sidewalls of conical portion 252 are inclined approximately 120 degrees from disk portion 253. The shape of opening 225 in front face 220 and the corresponding shape of the openings in wheel housing 240 determine the horizontal width of the slurry distribution. Wheel housing 240 and wheels 250 can be constructed out of polypropylene, polyvinylidene fluoride (PVDF), Kynar, any material with a teflon coating on exposed surfaces, or any other material inert to the slurry (e.g. a hard plastic). Fittings are typically teflon. Drains and supply lines, discussed below, are typically constructed of teflon or PVDF. All the corners of the interior of wheel housing 240 are rounded for ease of cleaning of slurry dispenser 124, as described below.

Slurry dispenser 124 also includes a sliding door 230, which can be closed to permit washing of the interior of wheel housing 240. Sliding door 230 is operated by air cylinder 335 enclosed in air cylinder housing 235, shown in Figures 6a and 6b. Water for cleaning is supplied from water inlet lines 343. Wheel housing 240 is drained through slurry drain lines 242 which are connected to slurry drain valves 243. During typical operation, wheel housing 240 is washed between polishing of each wafer without operator intervention.

Sliding door 230 also includes an attached pair of gutters 332. Gutters 332 are constructed of plastic with vinyl hinges. When sliding door 230 is closed, gutters 332 are folded inside and are washed by the water supplied from water inlet lines 343. When sliding door 230 is open, gutters 332 extend horizontally over openings 225 in front face 220, as shown in Figure 5, and protect the interior of wheel housing 240 from any liquid flowing down front face 220. During typical operation of slurry dispenser 124, water flows down front face 220. Sliding door 230 and gutter 332 advantageously allow the interior and exterior of wheel housing 240 to be washed without cross contamination. That is, slurry from inside wheel housing 240 is prevented from being washed onto the polishing pad attached to polishing belt 101, and exterior washing is prevented from diluting slurry inside wheel housing 240.

A third embodiment of the present invention is suitable for use with a polishing apparatus in which the polishing belt is vertically mounted but travels in a horizontal direction. (Consider, for example, rotating CMP apparatus 100 90 degrees in the plane of polishing pad 101). A rotating wheel in a slurry dispenser for such a polishing apparatus, unlike the rotating wheel in slurry dispenser 104 of Figures la and 1b (which rotates in a horizontal plane), rotates in a vertical plane. Clearly, in such an apparatus, the reservoir from which slurry are drawn cannot be provided in the same way as reservoir 205 of Figure 4. Figures 10a and 10b show, respectively, vertical and horizontal sections through a slurry dispenser 500 suitable for implementing this third embodiment of the present invention.

As shown in Figure 10a, slurry dispenser 500 sprays a stream of slurry from an opening 507 on the side of housing 505. A component wheel assembly 503, which is housed within housing 505, is rotated by a shaft 504 coupled to a variable speed motor 502 located outside of housing 505. As shown in Figure 10b, component wheel assembly 503 is partially immersed in a slurry reservoir 506 located at the bottom of housing 505, such that, when component wheel assembly 503 is rotated by shaft 504 in the direction indicated by reference numeral 503, slurry is carried by rotating component wheel assembly 503 and sprayed out of opening 507 of housing 505 by the centrifugal force. Partial wall 501a and side wall 501b of reservoir 506 serve to restrict the angle φ of spray in substantially the same manner as partial walls 301a and 301b in slurry dispenser 104 of Figures 3a and 3b.

The detailed description above is provided to illustrate the specific embodiments described herein and is not intended to be limiting. Numerous variations and modifications within the scope of the present invention are possible. For example, while the present invention is illustrated by a CMP apparatus, the present invention is suitable for use with any polishing apparatus. The present invention is defined by the following claims.

## Claims

1. A slurry dispenser, comprising:
a housing having a first opening;
a first reservoir provided within said housing for holding a slurry;
a first rotating mechanism; and
a first wheel assembly within said housing, said first wheel assembly engaged to rotate with said first rotating mechanism, said first wheel assembly including a first disk portion and a first conduit for carrying said slurry from said reservoir to said first disk portion, such that when said first wheel assembly is rotating, a stream of slurry is forced up said first conduit into said first disk portion and dispensed as a spray by said first disk portion through said first opening.

2. A slurry dispenser as in Claim 1, wherein said first conduit of said first wheel assembly comprises a conical member inserted into said first reservoir.

3. A slurry dispenser as in Claim 1 or 2, wherein said first disk portion includes a groove along the circumference of said disk portion.

4. A slurry dispenser as in Claim 1, 2 or 3, wherein said first rotating mechanism comprises a variable speed motor.

5. A slurry dispenser as claimed in any one of the preceding Claims, wherein said first wheel assembly and said housing comprises material chemically inert with respect to said slurry.

6. A slurry dispenser as in Claim 5, wherein said material comprises polyvinylidene fluoride (PVDF).

7. A slurry dispenser as in Claim 5, wherein said material comprises polycarbonate.

8. A slurry dispenser as in Claim 5, wherein said material comprises polypropylene.

9. A slurry dispenser as in Claim 5, wherein said material comprises a teflon coating.

10. A slurry dispenser as claimed in any one of the preceding Claims, wherein comprising wall portions within said housing provided proximately to said opening so as to restrict said spray to a predetermined angle.

11. A slurry disperser as claimed in any one of the preceding Claims, further comprising a first slurry inlet for providing a continuous supply of slurry into said first reservoir.

12. A slurry dispenser as claimed in any one of the preceding Claims, wherein said housing further comprises a second opening, and said slurry dispenser further comprising:
a second reservoir provided within said housing for holding a slurry;
a second rotating mechanism; and
a second wheel assembly within said housing, said second wheel assembly engaged to rotate with said second rotating mechanism, said second wheel assembly including a second disk portion and a second conduit for carrying said slurry from said reservoir to said second disk portion, such that when said first and said second wheel assemblies are rotating, streams of slurry are forced up said first and said second conduits into said first and second disk portions, respectively, and dispensed cooperatively as a spray by said first and second disk portions through said first and second openings, respectively.

13. A slurry dispenser as claimed in Claim 12, wherein said first and second rotating mechanisms are operated to rotate said first and second wheel assemblies in opposite directions.

14. A slurry dispenser as claimed in Claim 12 or 13, further comprising:
a sliding door with an open and a closed position, such that in the closed position, the sliding door covers said first and second openings in said housing,
an air cylinder operating said sliding door; and
water inlet lines for providing cleaning water to said housing.

15. A slurry dispenser as claimed in Claim 14, further comprising drain lines and drain valves for emptying said housing after cleaning.

16. A slurry dispenser as in Claim 15 further comprising gutters attached to said sliding door such that when said sliding door is in the open position, the gutters project over said first and second openings.
